(19) Europäisches Patentamt

European Patent Office

Office européen des brevets

(11) **EP 1 104 093 A1**

(12) **EUROPEAN PATENT APPLICATION**

(43) Date of publication:
**30.05.2001 Bulletin 2001/22**

(51) Int Cl.⁷: **H03F 1/32**

(21) Application number: **99850179.5**

(22) Date of filing: **24.11.1999**

(84) Designated Contracting States:
**AT BE CH CY DE DK ES FI FR GB GR IE IT LI LU MC NL PT SE**
Designated Extension States:
**AL LT LV MK RO SI**

(71) Applicant: **TELEFONAKTIEBOLAGET LM ERICSSON**
**126 25 Stockholm (SE)**

(72) Inventor: **Leyonhjelm, Scott**
**172 34 Sundbyberg (SE)**

(74) Representative: **Larfeldt, Helene et al**
**Bergenstrahle & Lindvall AB**
**Box 17704**
**118 93 Stockholm (SE)**

(54) **Method and apparatus for generation of a RF signal**

(57) The invention is concerned with a method and apparatus for linearisation of a radio frequency (RF) power amplifier by predistortion, wherin the following steps are performed: a) receiving a digitized base-band input signal, to be amplified by said RF power amplifier, b) performing digital predistortion signal of the signals to compensate for amplifier distortion, c) converting the signal to an analog signal via two D/A converters, d) performing analog frequency conversion to achieve a radio frequency (RF) signal, e) performing analog predistortion of the RF signal, and f) amplifying the analog predistorted signal by said RF power amplifier. The invention is also concerned with some alternative embodiments.

EP 1 104 093 A1

**Description**

**TECHNICAL FIELD**

The invention is concerned with a method and apparatus for generation of a RF signal, especially linear amplification of RF signals.

**BACKGROUND ART**

In a radio base station, there is a need for a high-power amplifier in the transmitter section to provide each radio channel with enough power to reach the outer limits of the cell which the base station is covering.

When the same amplifier is used for simultaneous amplification of several information signals modulated on different carrier waves or when linear modulation is used, such as QAM (Quadrature Amplitude Modulation), high amplifier linearity is required, because in this case it is essential that all phase and amplitude positions of the signal components involved are maintained in the amplification. Otherwise intermodulation between the signal components will occur and the spectrum of the amplified signal will broaden. The intermodulation distortion will interfere with signals on other channels. Examples of systems, wherein high linearity is required is amplification of several narrow-band signals and amplification of wide-band signals such as CDMA.

RF power amplifiers are inherently non-linear devices in that they generate unwanted intermodulation products, which manifest themselves as spurious signals in the amplified output signal, separate and distinct from the input signal. The distortion introduced by an RF amplifier causes the phase and amplitude of its amplified output signal to depart from the respective phase and amplitude of the input signal.

Different techniques exist to linearise amplifiers. An overview and reference list of linearisation techniques, including Back of off class A, Feedforward, Vector summation, Feedback and Predistortion Linearisation, is given in *"Linearisation of RF Power Amplifiers"* by Mark. A. Briffa, department of Electrical and Electronic Engineering, Victoria University of Technology, December 1996, Australia.

Predistortion is a technique which modifies the original input signal to the power amplifier, such that it is complementary to the distortion characteristics of the power amplifier. The cascaded response of the complementary predistortion and power amplifier should therefore result in an overall linear gain and phase transfer function. Typically the complementary predistortion function is based on the approximation of the amplifier being modelled by a power series (otherwise known as the AM/AM & AM/PM characteristic) (AM = amplitude modulation, PM = phase modulation). However, the complementary predistortion function could also include higher order effects, such as thermal properties of the power transistor and /or frequency dependent properties due to the bias and matching circuits. Predistortion can be applied at radio or Intermediate frequencies, known as analog predistortion, or applied at baseband, known as digital predistortion. Additionally to achieve excellent linearity, adaption of the predistortion means is needed to circumvent changes due temperature, component ageing etc.

The predistortion mechanism may be made adaptive by extracting the error distortion signal component in the output of the RF amplifier and adjusting the predistortion signal in accordance with the such extracted error behaviour of the RF amplifier during real-time operation, so as to effectively continuously minimize distortion in the amplifier's output. A good overview of digital predistortion adaptive means are described in J. K. Cavers, "Amplifier linearisation by adaptive predistortion", US patent 5,049,832, whilst the international patent applications WO 99/45638 and WO 99/45640 are examples of an analog predistortion adaptive means.

To achieve good results with analog predistortion, excellent matching of the complementary predistortion function and amplifier distortion function is required. Analog parts with excellent matching characteristics are, however, very difficult and expensive to produce. Even when analog predistortion is adapted by either the average or peak error, the results are limited in accuracy and therefore can only produce limited performance improvements.

Adaptive digital predistortion on the other hand, can in theory produce the excellent matching properties required to achieve significant improvements in linearity. However, because the predistortion occurs at baseband, it needs to be converted to the radio frequency (RF) before it can be amplified. The frequency conversion, however, takes place in the analog domain, which by its nature destroys the perfect matching capabilities of the digital domain. The result is that digital predistortion also becomes limited in performance.

The frequency dependent properties of the analog frequency conversion process, amplitude ripple and phase ripple, are the basic mechanisms for destroying the digital domain's matching qualities. Both these quantities are directly linked to the amount of performance improvement that can be obtained. As the amplitude and phase ripple quantities increases, then the obtainable linearity performance improvement reduces, regardless of how well matched the complementary function is in the digital domain.

Analog and digital predistortion linearisation are typically implemented as standalone techniques, because of practical implementation problems arising from the fact that the two solutions require different architectures for implementation. This is best illustrated in the following two examples. In a normal macro base station, the Power Amplifier (PA) is a module that fits in one part of the rack, sometimes included with the frequency conversion circuits. The digital base band processing circuits physically reside in another part of the rack. These two components are physically separated and the signals are communicated via a coaxial cable. In the mast mounted antenna application, the PA is at the top of the mast and the base band processing part is at the base of the mast. In both examples, the digital baseband processing parts and the PA module are physically separated, which makes them practically very difficult to combine.

Some examples of a combined linearisation solution, however, exist. For example the combination of digital predistortion with feedforward is presented in WO 98/12800. The feedforward architecture requires additional signal paths and two couplers, one to acquire the signal out of the power amplifier (PA) and the other to subtract the remaining PA distortion. The last coupler inserts a loss. The result is that the overall efficiency is degraded even if a combination of the two techniques are used. The solution is also quite complicated requiring a large amount of components making it difficult to implement.

Another example combining RF predistortion with Feedforward is described in the technology white paper, Multi-Carrier Power Amplifiers join the Digital Revolution' Yuval Shalom, Fall 1999 issue of Site management and Technology Magazine, Intertec Publishing. It states that the DC-RF efficiency of feedforward amplifiers is limited to around 6-8% because of three factors.

1) Large backoffs due to the large peak to average ratios of multicarrier (wideband) signals. The DC power supplied to the power amplifier is given by $P_{DCamp}$, and the RF output power from the amplifier is given by $P_{RF}$.

2) Additional hardware such as delay lines and couplers after the power amplifier introduce insertion (power) loss. The power loss can be defined as a fraction of the total power surviving after the loss, typically 0.8 i.e 20% (1 dB) of power is lost.

3) DC power consumed ($P_{DCother}$) by other parts of the feedforward system i.e. error amplifiers, control circuitry.

The DC-RF efficiency formula can be approximately written for the combined feedforward and RF predistortion system as

$$\text{DC-RF efficiency} = 0.8 * P_{RF}/ (P_{DCother} + P_{Dcamp})$$

In the case of just a predistortion system then compared to the feedforward system there is the removal of additional hardware that introduces losses and the other parts of the feedforward system, this reduces complexity and results in the DC-RF efficiency to increase as shown below where the DC-RF efficiency formula for predistortion becomes

$$\text{DC-RF efficiency} = P_{RF}/ P_{Dcamp} > 0.8 * P_{RF}/ (P_{DCother} + P_{Dcamp})$$

Wide band applications partly have to be designed with different architectures and solutions than the narrow band solutions because of different problems.

Predistortion is an open loop power amplification system, as opposed to a closed loop system. Closed loop systems are based on feedback, i.e. cartesian feedback, envelope feedback, polar feedback.

The advantage with open loop systems is that both narrowband and wideband systems can be transmitted. In the order of 10's of MHz, whereas closed systems are limited to narrow band signals In the order of 100's of kHz for practical stability reasons, although they can however usually achieve higher levels of linearisation than open loop systems.

In addition to open and closed loop systems, feedforward amplification can be used that can achieve both high levels of linearity and transmit wideband signals. Compared to predistortion techniques it requires a rather complicated gain and phase tracking mechanism to keep the loops in balance and has low power efficiency. The feedforward architecture is currently the most widely used technique for linearising applications in wideband radio. For wideband radio applications, predistortion, both analog and digital techniques in general has a characteristic of good power efficiency, when compared to the use of the feedforward technique, but they have lower linearity performance than feedforward.

Digital predistortion has not been technologically possible to use for wide band signals earlier with a sufficient performance because of a relatively slow digital signal processing and low speed and precision. Due to the development of faster digital signal processing, for example digital circuit fabrication techniques and advancements in DAC (Digital to Analog Converter) technology, this is not a hinder anymore. Use of digital predistortion techniques in wide band systems, however, accentuates the problems in connection with the upconversion of the base band signal to a radio signal since the frequency dependent properties of the analog frequency conversion process limit the improvement in performance.

The analog frequency upconversion process is usually assumed to have the same transfer function regardless of frequency,

$$Y = f^n(X)$$

wherein Y is the output signal, and is a function of the input signal X. Typically the frequency conversion circuitry is designed such that Y is linearly related to X, and this assumption is relevant to narrow band signals. In wideband signal applications, the frequency upconversion process becomes also dependent on frequency

$$Y = f^n(X, frequency)$$

This frequency dependence destroys the perfect digital predistortion matching properties, and therefore limits the amount of linearisation. The dependence on frequency can be reduced, but it becomes expensive, if not impractical, to design over a wide bandwidth with very low amplitude and phase ripple. That is, low enough amplitude and phase ripple that allow digital predistortion to achieve the desired level of linearity. A digital frequency equaliser could be used to negate the frequency upconverters frequency dependence, however there will always exist some residual frequency dependence that limits the amount of linearisation, and it will also increase the complexity of the solution.

The object of the invention is to develop an improved linearisation method by using digital predistortion to be used in both wide and narrow band applications, which overcome the frequency conversion problems with digital predistortion.

## SUMMARY OF THE INVENTION

The method of the invention for linearisation of a radio frequency (RF) power amplifier by predistortion, comprises the steps of

    receiving a digitized base-band input signal, to be amplified by said RF power amplifier,
    performing digital predistortion signal of the signals to compensate for amplifier distortion,
    converting the signal to an analog signal via two D/A converters,
    performing analog frequency conversion to achieve a radio frequency (RF) signal,
    performing analog predistortion of the RF signal,
    amplifying the analog predistorted signal by said RF power amplifier.

The power amplifier of the invention is characterized by means of performing the above steps of the invention. In alternative, the digitally predistorted signal could be converted to a low intermediate frequency in the method and the power amplifier of the invention, whereafter the signal can be converted to an analog signal by using only one D/A converter. Both these solutions can also be used in such another architecture of the invention, wherein the received baseband input signal can be split into two signals of 90° phase difference, wherafter the rest of the steps of the method of the invention is performed for each of the signals.

In all the different embodiments of the invention, the predistortions can be made adaptive to further improve the performance and/or circumvent changes due to temperature, component ageing etc.

Furthermore, the invention can be used in connection with different architectures described later.

The invention has several advantages compared to prior predistortion solutions. By solving the upconversion problems caused by the digital predistortion process by splitting the performance requirements between digital and analog predistortion, improved linearity is achieved compared to digital predistortion alone. The solution of the invention also gives a higher efficiency compared to feedforward linearisation techniques, especially for wide band systems.

The invention also has the advantage of reduced requirements on frequency conversion parts since the linearisation performance now partly is handled by the analog predistortion means. This results in a cheaper frequency conversion solution.

The physical separation of the digital baseband processing parts and the PA module in prior art solutions exemplified above was one of the problems to overcome so that a combination of analog and digital predistortion would be possible.

One of the merits of the invention also lies in the fact that the overall performance improvement can be enhanced by splitting it between digital predistortion and analog predistortion. For example, if the basic amplifier gives a performance of -30dBc and 30dB improvement is required, an overall performance of the linearisation of-60dBc is needed. Then digital predistortion could be allocated an improvement of 20 dB and the analog predistortion 10dB. This makes a total linearisation solution possible, which is very difficult practically or impossible to achieve with digital or analog predistortion alone. For digital predistortion to achieve this alone would require stringent design requirements on the frequency upconverter resulting in either an impossible design requirement or a very expensive solution. For analog predistortion to achieve this alone would require excellent matching of the complementary predistortion function and amplifier distortion function is required, and analog parts with excellent matching characteristics are very difficult and expensive to produce.

In the following, the invention is for illustrative purposes described by means of figures in connection with some selected architectures. The invention is not restricted to the details of the figures, since the invention can e.g. be applied in other architectures, be made adaptive etc.

**FIGURES**

Figure 1 is a schematic diagram of the principle of the invention
Figure 2 shows the Doherty amplifier architecture of prior art
Figure 3 shows an example of an embodiment of the invention implemented in the Doherty architecture
Figure 4 shows an example of the digital predistortion part of the invention more in detail
Figure 5 shows an example of the the analog predistortion part of the invention more in detail
Figure 6 shows simulation results of a digital predistortion method of prior art
Figure 7 shows simulation results of the method of the invention

**DETAILED DESCRIPTION**

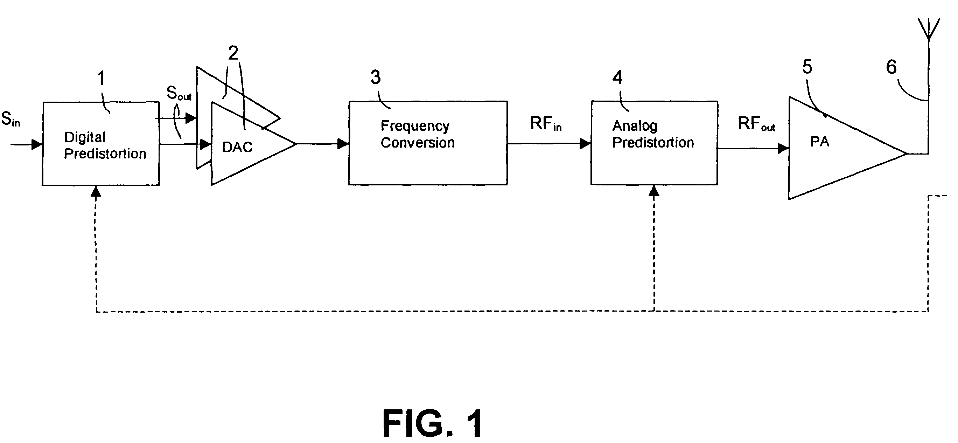

The invention is presented schematically in figure 1. A digitized complex base band input signal $S_{in}$ to be converted to a RF signal and then amplified is received. The digital complex baseband signal, $S_{in}$, is first predistorted 1 in a complementary manner to the combination of the analog predistorter 4 and power amplifier 5 (the combination of the analog predistorter 4 and the power amplifier 5 can be thought of as a more linear power amplifier). The complex baseband digital predistorted signal, $S_{out}$, is then converted to an analog signal via two Digital to Analog Converters (DAC), 2. Alternatively the baseband digital predistorted signal can be digitally frequency converted, before being converted to an analog signal via a single Digital to Analog Converters (DAC) (The alternative solution is not shown in the figure). The signal/s out of the DAC shall now be frequency converted up to RF 3. The frequency conversion circuits consist of mixers, filters, amplifiers etc arranged in ways obvious to the man skilled in the art. It is the frequency conversion process that introduces frequency dependent amplitude and phase ripple, that partly destroys the linearisation ability that can be achieved with digital predistortion alone. The RF signal (which contains the frequency converted digitally predistorted signal), $RF_{in}$, is now predistorted 4, in a complementary manner to the power amplifier. The RF predistorted signal, $RF_{out}$, is then passed through the power amplifier 5 before being transmitted by the antenna 6.

The digital and analog predistorters can optionally be made adaptive to further improve the linear performance and/or circumvent changes due to temperature & ageing etc. The adaption operation, which can be carried out with methods known in themselves, is indicated with a dotted line in figure 1.

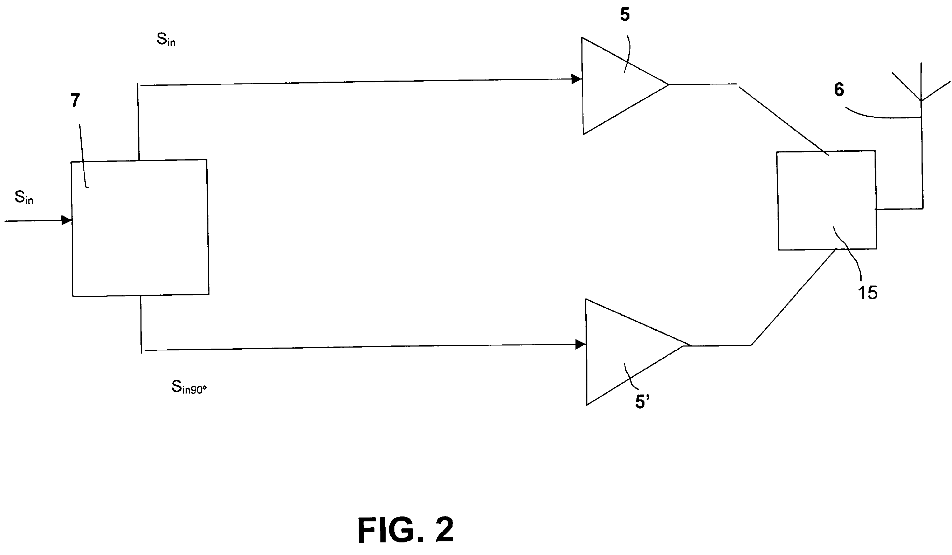

Figure 2 illustrates the so called Doherty amplifier. The architecture of a Doherty amplifier is for example described in "RF Power Amplifiers for Wireless Communications" by Steve C. Cripps (ISBN 0-89006-989-1, Artech House, 685 Canton Street, Norwood MA 02062). According to the basic concept of this amplifier, two devices are used and the final maximum RF output power is the combined power of both devices. The Doherty amplifier is an efficiency enhancement technique compared to a one device technique, but does not introduce any linearisation improvements. The incoming base-band signal $S_{in}$ is quadrature split 7 into two signals with 90° phase difference. The signals are then amplified in 5, 5' and combined in 15 and transmitted by the antenna 6.

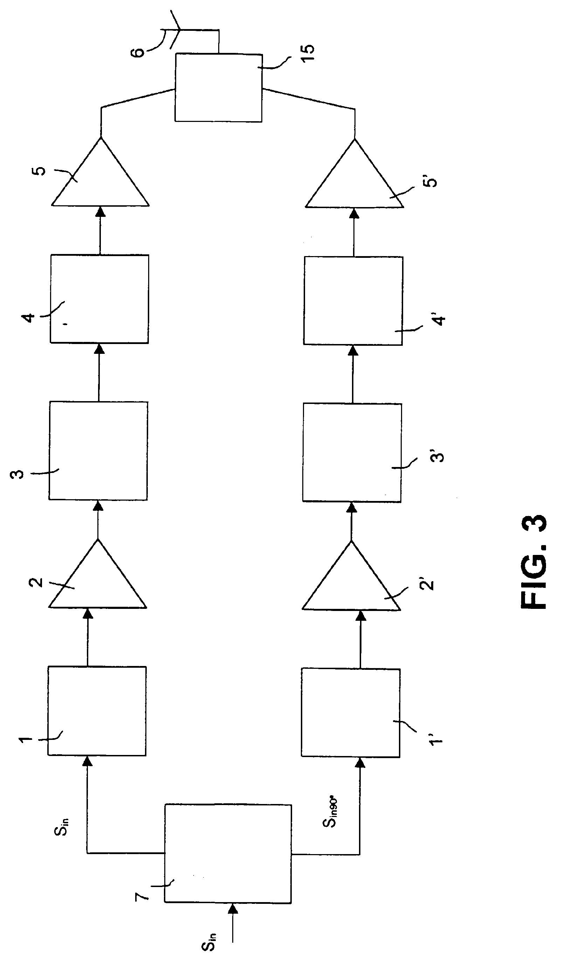

The performance of the Doherty amplifier can be improved with respect to the linearity by implementing with the solution of the invention according to figure 3. The incoming base-band signal $S_{in}$ is first split 7 into two signals $S_{in}$, $S_{in90°}$, one signal being identical to the input signal and the other signal having a 90 degree phase shift. The 90 degree phase shift can be implemented by the Hilbert Transform or ways obvious to the man skilled in the art. The two signals in figure 3 are each processed as in figure 1 in accordance with reference numbers 1, 2, 3, 4 and 5 respective 1', 2', 3', 4' and 5'. The only difference being the top path, with the original signal, consists of the main power amplifier, whilst the lower path, with the 90 degree phase shifted signal, consists of the peak or auxiliary amplifier. The output signals from the amplifiers are then combined 8 such that the top signal path (Main amplifier) is shifted by 90 degrees before the combination. The combination is typically implemented as a quarter wave delay after the main power amplifier output with the output of the carrier amplifier, the third port being the combined output signal which is then transmitted by the antenna 6.

The invention when applied to the Doherty architecture will improve the linearity of the power amplifiers used, and make it more suitable for use in radio communication systems, both narrowband and wideband systems.

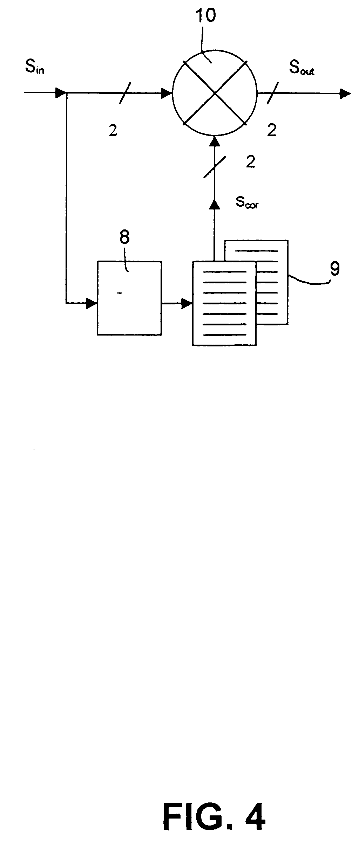

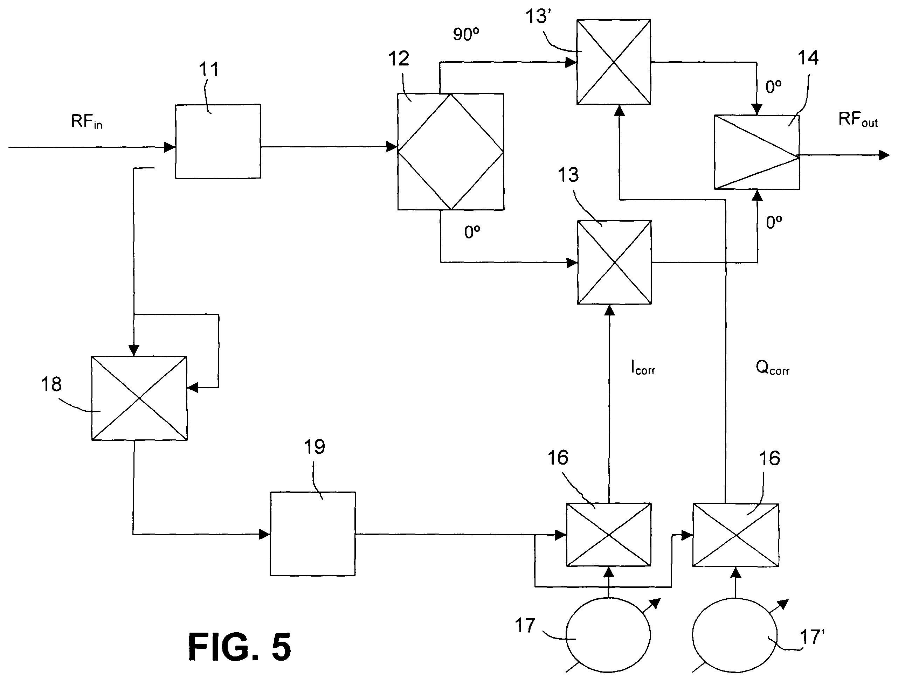

Figures 4 & 5 illustrate some simple examples of digital and analog predistortion techniques that can be used in the invention, assuming in these figures that the amplifier is memoryless. That is AM/AM (amplitude modulation/ amplitude modulation), AM/PM (amplitude modulation/phase modulation) model of the amplifier is assumed. If the power amplifier has memory effects such as thermal properties of the power transistor and /or frequency dependent properties due to the bias and matching circuits, then it is obvious to the man skilled in the art that the digital and analog predistorters will also require memory to compensate for these effects. An example of a digital and an analog predistorter will now be described, which can be used in the inventive combination of analog and predistortion techniques of the invention.

Figure 4 is an example of a method to implement digital predistortion according to reference number 1 in figure 1. The digital predistorter in this case is assumed to compensate for the combination of the analog predistorter and power amplifier with a memoryless non-linearity and is based on cartesian complex gain predistortion. Other memoryless predistorter examples could include polar complex gain or full cartesian mapping, the principle of which is described in US patent 5,049,832. The complex baseband input digital signal, $S_{in}$, is connected to an address generator 8. The address generator generates an address based on a function of the amplitude of the signal (this is consistent with the memory non-linearity assumption of the power amplifier in this example). The address is typically the amplitude or power of $S_{in}$. The address is then used to select the complementary complex gain, $S_{corr}$, from the correction (predistortion) tables 9 for that digital sample. The correction tables contain the total complementary complex gain of the combination of the analog predistorter and power amplifier, such that the combination of the complementary gain of the digital predistorter and the analog predistorter and the power amplifier results in linear gain and phase for all input signals magnitudes. The complementary complex gain sample, $S_{corr}$, and the orignal input signal sample, $S_{in}$, are then processed by a complex multiplier 10. The output of the complex multiplier 10, $S_{out}$, is designed to linearise the combination of the analog predistorter and power amplifier. The signals used in figure 4 are complex, which is illustrated by number 2 at the signal paths.

Figure 5 is an example to perform a $3^{rd}$ order analog RF predistortion according to reference number 4 in figure 1. The digitally predistorted signal converted to RF is input into the analog predistorter, $RF_{in}$. The $RF_{in}$ signal is delayed 11 to ensure that RF signal and correction signals coincide at the multipliers 13, 13'. The delayed $RF_{in}$ signal is then split into two signals with quadrature phase, that is a 90 degree phase shift between the two signals. Both quadrature signals are then mixed 13,13' with the correction (predistortion), $I_{corr}$ and $Q_{corr}$, signals. These signals, $I_{corr}$ and $Q_{corr}$, represent the analog complementary complex gain of the amplifier. The resulting mixed signals are then combined in phase with a hybrid combiner 14. The output of the analog predistorter, $RF_{out}$, is designed to linearise the power amplifier. The correction signals, $I_{corr}$ and $Q_{corr}$, are generated by first squaring 18 the input signal, then filtering 19 away the unwanted harmonics generated by the squaring function, and finally multiplying the filtered signal with two third order coefficients 17, 17'. The two third order coefficients approximate the complementary complex gain of the amplifier. It is obvious to those familiar with the state of the art that higher order coefficients can be used to achieve better matching of the complementary gain of the amplifier and that there are many other examples of analog RF predistorters, some of which are described in Mark Briffa, "Linearisation of RF Power Amplifiers", PhD thesis, 1996, department of Electrical and Electronic Engineering, Victoria University of Technology, December 1996, Australia and the international patent applications WO 99/45640 and WO 99/45638.

## SIMULATION RESULTS

By solving the frequency conversion problems caused by the digital predistortion process by splitting the performance requirements between digital and analog presdistortion in a way according to the invention, improved linearity is achieved compared to digital predistortion alone. The solution of the invention also gives a higher efficiency compared to feedforward linearisation techniques, especially for wide band systems.

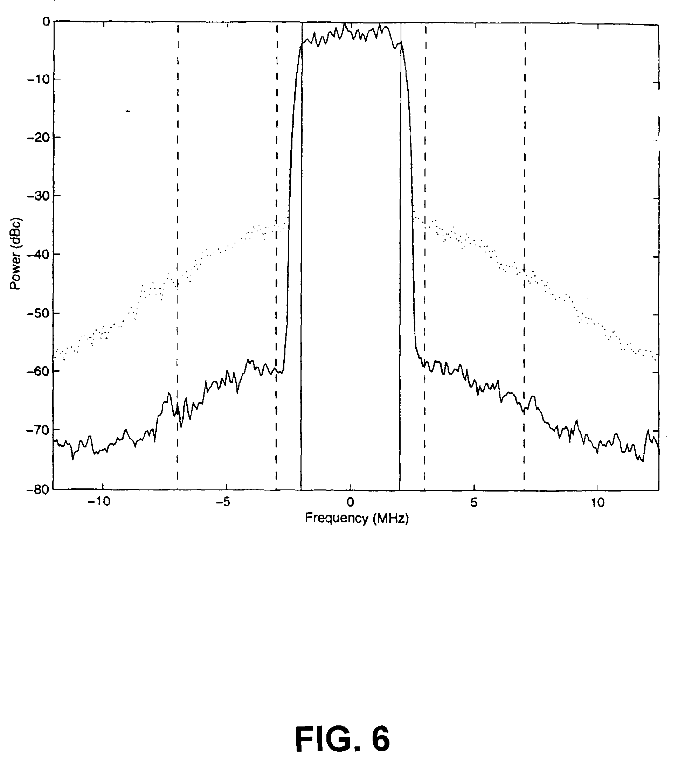

This can be shown through the following simulation results using a WCDMA signal with a bandwidth of 4.096MHz. Digital predistortion linearisation only with a given power amplifier is first assumed, See figure 6.

The adjacent channel performance, or linearity performance, of the amplifier is defined as the ratio of the power of a signal to the power of adjacent signal power, either the lower and the upper sides. The power is calculated by integrating the energy over a bandwidth of 4.096 MHz. For the signal this is shown as the area between the two vertical solid lines, and for the adjacent signal this is shown as the area between the dotted vertical lines.

The adjacent channel performance of the given amplifier alone (shown dotted in figure 6) is 35.8 dBc and 34.4 dBc for the lower and upper adjacent channels respectively. Applying perfect digital predistortion (the ideal complementary function of the given power amplifier) with 0.6dB peak to peak amplitude ripple in the frequency converter results in an adjacent channel performance of (shown solid in figure 6) is 59.2 dBc and 58.8 dBc for the lower and upper adjacent channels respectively. The performance of the given power amplifier has been improved by digital predistortion by 23.4 and 24.4 dB.

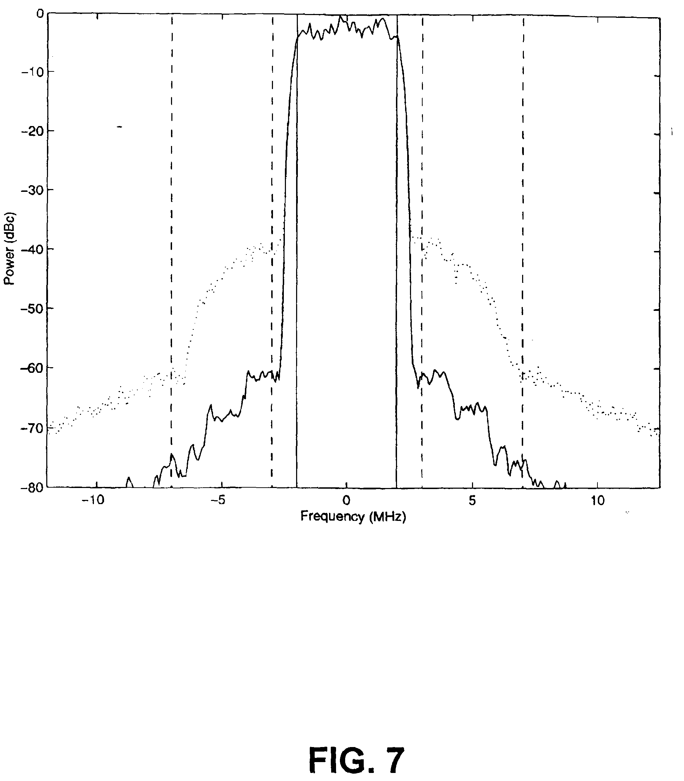

In the next set of results, the given amplifier is first predistorted by a RF analog predistorter, see Figure 6. The adjacent channel performance of (shown dotted in figure 7) is 41.1 dBc and 40.6 dBc for the lower and upper adjacent channels respectively. The analog predistorter has improved the given power amplifier by 5.3 dB and 5.2 dB. Notice that the analog predistorter has improved the higher order distortions of the amplifier in this example.

Digital predistortion is now applied to the analog predistorter and the given power amplifier. Perfect digital predistortion (the ideal complementary function of the analog predistorter and given power amplifier) with 0.6dB peak to peak amplitude ripple in the frequency converter results in an adjacent channel performance of (shown solid in figure 7) is 63.1 dBc and 62.8 dBc for the lower and upper adjacent channels respectively. Obviously the performance of the analog predistorter and given power amplifier has been improved by a further 22 and 22.2 dB with the addition of digital predistortion.

Notice that the overall performance improvement of digital predistortion in both examples was 23-24 and 22dB. Given measurement tolerances these values could be considered very similar. Digital predistortion has therefore been limited in performance by the ripple of the frequency upconverter, regardless of the initial linear performance of the analog parts. Additionally the overall performance improvement generated by the combination of analog and digital predistortion techniques is given by the sum of the individual improvements.

**Claims**

1. Method for linearisation of a radio frequency (RF) power amplifier by predistortion, comprising the steps of

   a) receiving a digitized base-band input signal, to be amplified by said RF power amplifier,
   b) performing digital predistortion signal of the signals to compensate for amplifier distortion,
   c) converting the signal to an analog signal via two D/A converters,
   d) performing analog frequency conversion to achieve a radio frequency (RF) signal,
   e) performing analog predistortion of the RF signal,
   f) amplifying the analog predistorted signal by said RF power amplifier.

2. Method for linearisation of a radio frequency (RF) power amplifier by predistortion, comprising the steps of

   a) receiving a digitized base-band input signal, to be amplified by said RF power amplifier,
   b) performing digital predistortion signal of the signals to compensate for amplifier distortion,
   c) converting the digitally predistorted signal to a low intermediate frequency,
   d) converting the signal to an analog signal via a D/A converter,
   e) performing analog frequency conversion to achieve a radio frequency (RF) signal,
   f) performing analog predistortion of the RF signal,
   g) amplifying the analog predistorted signal by said RF power amplifier.

3. Method of claim 1 or 2, **characterized** in that the analog predistortion mechanism is made adaptive by extracting the error signal component in the output of the RF amplifier and adjusting the predistortion signal in accordance with the such extracted error behaviour of the RF amplifier.

4. Method of any of claims 1 - 3, **characterized** in that the digital predistortion mechanism is made adaptive by extracting the error signal component in the output of the RF amplifier and adjusting the predistortion signal in accordance with the such extracted error behaviour of the RF amplifier during real-time operation.

5. Method of any of claims 1 - 4, **characterized** in that the baseband input signal received in step a) is split into two signals with 90° phase difference, whereafter the rest of the steps are carried out for each of the signals.

6. Power amplifier for linear amplification of radio frequency (RF) signals, comprising

a) means for receiving a base-band input signal,
b) means for digital predistortion of the input signal,
c) two D/A converters,
d) means for performing analog frequency conversion to achieve a radio frequency (RF) signal,
e) means for performing analog predistortion,
f) a power amplifier.

**7.** Power amplifier for linear amplification of radio frequency (RF) signals, comprising

a) means for receiving a base-band input signal,
b) means for digital predistortion of the input signal,
c) means for converting the digitally predistorted signal to a low intermediate frequency,
d) a D/A converter,
e) means for performing analog frequency conversion to achieve a radio frequency (RF) signal,
f) means for performing analog predistortion,
g) a power amplifier.

**8.** Power amplifier for linear amplification of radio frequency (RF) signals, comprising

a) means for receiving a base-band input signal,
b) means for splitting the received input signal into two signals with 90° phase difference, and for each of the signals
c) means for digital predistortion of the input signal,
two D/A converters,
d) means for performing analog frequency conversion to achieve a radio requency (RF) signal,
e) means for performing analog predistortion,
f) a power amplifier, and
g) means for combining the processed signals.

**9.** Power amplifier for linear amplification of radio frequency (RF) signals, comprising

a) means for receiving a base-band input signal,
b) means for splitting the received input signal into two signals with 90° phase difference, and for each of the signals
c) means for digital predistortion of the input signal,
d) means for converting the digitally predistorted signal to a low intermediate frequency,
e) a D/A converter,
f) means for performing analog frequency conversion to achieve a radio frequency (RF) signal,
g) means for performing analog predistortion,
h) a power amplifier, and
i) means for combining the processed signals.

FIG. 1

EP 1 104 093 A1

EP 1 104 093 A1

$S_{in}$

7

$S_{in}$

$S_{in90°}$

5

5'

6

15

**FIG. 2**

**FIG. 3**

# FIG. 4

FIG. 5

EP 1 104 093 A1

**FIG. 6**

14

# FIG. 7

**European Patent Office**

# EUROPEAN SEARCH REPORT

Application Number

EP 99 85 0179

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 898 338 A (PROCTOR JAMES A ET AL) 27 April 1999 (1999-04-27) | 1,3,4,6, 8 | H03F1/32 |
| Y | * the whole document * | 2,5,7,9 | |
| Y | US 4 291 277 A (BOYD ROBERT W ET AL) 22 September 1981 (1981-09-22) | 2,5,7,9 | |
| A | * the whole document * | 1,3,4,6, 8 | |

TECHNICAL FIELDS SEARCHED (Int.Cl.7)

H03F

The present search report has been drawn up for all claims

| Place of search | Date of completion of the search | Examiner |
|---|---|---|
| THE HAGUE | 11 May 2000 | Segaert, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**          EP 99 85 0179

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2000

| Patent document cited in search report | | Publication date | Patent family member(s) | | Publication date |
|---|---|---|---|---|---|
| US 5898338 | A | 27-04-1999 | EP | 0928515 A | 14-07-1999 |
| | | | WO | 9812800 A | 26-03-1998 |
| | | | US | 5949283 A | 07-09-1999 |
| US 4291277 | A | 22-09-1981 | NONE | | |

EPO FORM P0459

For more details about this annex : see Official Journal of the European Patent Office, No. 12/82